# EUROPEAN PATENT APPLICATION

(11) **EP 1 452 623 A1**
(43) Date of publication of application: **01.09.2004**
(21) Application number: 04251111.3
(22) Date of filing: 27.02.2004
(51) Int. Cl.: C23C 16/00

(54) **Precursor solution and method for controlling the composition of MOCVD deposited PCMO**

(30) Priority: 27.02.2003 US 377244
(71) Applicant: SHARP KABUSHIKI KAISHA, Osaka 545-8522 (JP)
(72) Inventor: Li, Tingkai, Vancouver, WA 98683 (US); Zhuang, Weiwei, Vancouver, WA 98683 (US); Charneski, Lawrence J., Vancouver, WA 98661 (US); Evans, David R., Beaverton, OR 97007 (US); Hsu, Sheng Teng, Camas, WA 98607 (US)
(74) Representative: Brown, Kenneth Richard

(57) **Abstract**

A single solution MOCVD precursor is provided for depositing PCMO. An MOCVD process is provided, for controlling the composition of PCMO by determining the deposition rate of each metal component within the precursor solution and determining the molar ratio. of the metals based on the deposition rates of each within the temperature ranges for substrate temperature and vaporizer temperature, and the composition of PCMO to be deposited. The composition of the PCMO is further controlled by adjusting the substrate temperature, the vaporizer temperature or both.

## Description

### BACKGROUND OF THE INVENTION

The present invention relates to metal oxide thin films, metalorganic precursors, and metalorganic chemical vapor deposition (MOCVD), especially as related to the formation of resistive memory materials.

New materials, referred to herein as resistive memory materials, are now making it possible to produce non-volatile memory cells based on a change in resistance. Materials having a perovskite structure, among them colossal magnetoresistance (CMR) materials, are materials that have electrical resistance characteristics that can be changed, by external influences.

For instance, the properties of materials having perovskite structures, especially for CMR, can be modified by applying one or more short electrical pulses to a thin film or bulk material. The electric field strength or electric current density from the pulse, or pulses, is sufficient to switch the physical state of the materials so as to modify the properties of the material. The pulse is of low enough energy so as not to destroy, or significantly damage, the material. Multiple pulses may be applied to the material to produce incremental changes in properties of the material. One of the properties that can be changed is the resistance of the material. The change may be at least partially reversible using pulses of opposite polarity, or the same polarity but with lower amplitude and wider width, from those used to induce the initial change.

One of the promising materials for these applications is PrₓCa₁₋ₓMnO₃, also referred to as PCMO. Due, to the higher evaporation temperatures, lower vapor pressures and poor thermal stability of available MOCVD precursors for PCMO deposition, it has been difficult to control the composition of the deposited PCMO films. It has also been difficult to ensure the reproducibility of the PCMO films produced.

### SUMMARY OF THE INVENTION

A single solution MOCVD precurosr for depositing PCMO is provided comprising a Pr(tmhd)₃ precursor, a Mn(tmhd)₃ precursor and a calcium precursor dissolved in an organic solvent. The calcium precursor may be Ca(tmhd)₂ or Ca(hfac)₂ for example.

An MOCVD process is also provided. A substrate is placed within a chamber on a chuck capable of controlling the temperature of the substrate. Oxygen is introduced into the chamber to react with metalorganic precursors to produce PCMO. The substrate is heated to a predetermined substrate temperature. A vaporizer attached to the chamber is also heated to a predetermined vaporizer temperature. A single solution of metalorganic precursors, which has a predetermined molar ratio of metals dissolved in an organic solvent, is introduced into the vaporizer, where it is vaporized. The vaporized precursor is then delivered into the chamber by a carrier gas. A thin film of PCMO is thus deposited onto the substrate. The composition of the resulting film is determined to a first approximation by the molar ratio of the metalorganic precursors. The final composition can be further controlled by determining appropriate values for the substrate temperature and the vaporizer temperature, as these temperatures change the deposition rates of the metalorganic precursors such that the ratio of metals in the final PCMO material can be adjusted.

### BRIEF DESCRIPTION OF THE DRAWINGS

Fig. 1 is a scematic view of a CVD chamber for use with a single solution liquid precursor.
Fig. 2 shows the effect of substrate temperature on Pr deposition rates.
Fig. 3 shows the effect of vaporizer temperature on Pr deposition rates.
Fig. 4 shows the effect of substrate temperature on Ca deposition rates.
Fig. 5 shows the effect of vaporizer temperature on Ca deposition rates.
Fig. 6 shows the effect of substrate temperature on Mn deposition rates.
Fig. 7 shows the effect of vaporizer temperature on Mn deposition rates.
Fig. 8 shows the composition of PCMO using EDX for a 500 °C substrate temperature and a 270 °C vaporizer temperature.
Fig. 9 shows the composition of PCMO using EDX for a 500 °C substrate temperature and a 275 °C vaporizer temperature.
Fig. 10 shows the composition of PCMO using EDX for a 400 °C substrate temperature and a 275°C vaporizer temperature.
Fig. 11 shows the composition of PCMO using EDX for a 450 °C substrate temperature and a 275°C vaporizer temperature.
Fig. 12 shows the composition of PCMO using EDX for a 500 °C substrate temperature and a 275 °C vaporizer temperature.

### DETAILED DESCRIPTION OF THE INVENTION

One of the most promising materials for use in resistive memory applications is PCMO. Accordingly precursors for use in metalorganic chemical vapor deposition (MOCVD) processes, and methods for preparing and using these precursors to deposit PCMO are provided.

The precursors for MOCVD processes comprise solid organometallic compounds and liquid organic solvents. Liquid precursors are produced by dissolving the solid organometallic compounds in the organic solvents.

The preferred organic solvents will not react with the solid oxganometallic compounds being dissolved. The preferred organic solvents will provide high solubility of the solid organometallic compounds being dissolved. The resulting liquid precursor will preferably be stable for a. reasonable amount of time, meaning that there will preferably be little or no solid precipitation during a reasonable storage period. The liquid precursor may contain different organometallic compounds, which should preferably not react with each other. The organometallic compounds dissolved in the liquid precursor are preferably volatile at the temperatures and pressures used for the MOCVD process. The use of organic solvents to produce a liquid precursor will preferably not degrade the volatile properties of the solid organometallic compounds dissolved therein during a reasonable storage time. A reasonable storage time would preferably be greater than approximately two weeks. Although, the above properties are preferred, it may be possible to produce a suitable precursor that does not have all of the preferred properties described above. Examples of suitable organic solvents include octane, THF, butylether, butyl acetate, tetraglyme and iso-propanol.

The preferred solid metalorganic precursors for use in MOCVD deposition of PCMO include Mn(tmhd)₃, Pr(tmhd)₃, and Ca(tmhd)₂. Ca(tmhd)₂ may be replaced by Ca(hfac)₂.

In an embodiment of the precursor solution, the solid metalorganic precursors Mn(tmhd)₃, Pr(tmhd)₃, and Ca(tmhd)₂ are dissolved in a mixture of butylether and tetraglyme. Butylether provides for good dissolution, of the organometallic compounds, while tetraglyme provides for stable precursor delivery at high temperature without blocking delivery lines. The precursor solution may be prepared with a concentration of 0.1 moles/liter of each metalorganic precursor. Ca(tmhd)₂ is preferable if the presence of fluorine is undesirable.

In another embodiment of the precursor solution, Ca(hfac)₂ is used in place of Ca(tmhd)₂, because Ca(hfac)₂ is, more volatile at lower tamperatures, which may be desirable for some processes. The volatility of Ca(hfac)₂ is better matched to the volatility of Mn(tmhd)₃, and Pr(tmhd)₃, which may make it more suitable for some processes.

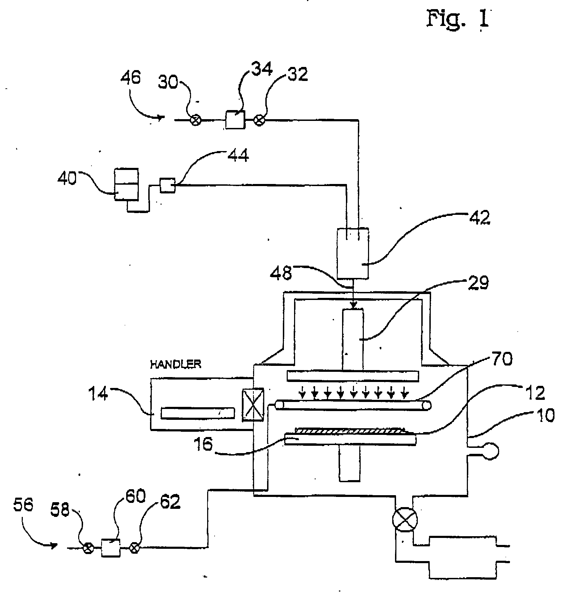

Fig. 1 shows a schematic illustration of the CVD chamber 10 for performing an MOCVD process using a liquid precursor 40. The substrate 12 is placed within the CVD chamber 10. The substrate 12 may be introduced into the chamber 10 through the handler 14 and placed on a chuck 16. The chuck 16 commonly has a heating element so that the chuck and the substrate temperature can be controlled. The liquid precursor 40 will be injected into a vaporizer 42 by a micro-pump 44, or alternatively a liquid flow meter or other liquid delivery system. The liquid precursor will be vaporized to a gas state in the vaporizer and delivered into the chamber 10 by a carrier gas 46. The carrier gas is preferably nitrogen or argon. The vaporizer 42 along with the delivery lines 48 can be heated to a controlled temperature to help vaporize the precursor and reduce, or eliminate, deposition within the delivery lines. A gas valve 30 may be used to control the flow of the carrier gas into the vaporizer. The second valve 32 may be used to further control the flow of the carrier gas into, the chamber 10. In addition, the mass flow controller 34 may be used to further regulate the flow into the chamber 10, possibly through a showerhead, or a gas distributor 29. A source of oxygen 56 is provided through a valve 58, a mass flow controller (MFC) 60 and a second valve 62 into the chamber 10. Within the chamber 10, the oxygen is delivered to a ring 70. The ring 70 is a toroid that is positioned slightly below the gas distributor 29 and directs the oxygen towards the center of the toroid where it can react with precursor vapors at the surface of the substrate 12, The oxygen is incorporated into the PCMO thin film on the substrate during MOCVD processing.

Due to the higher evaporation temperatures, lower vapor pressures and poor thermal stability of the MOCVD precursors for depositing PCMO thin film materials, the composition of PCMO thin film materials is not easy to control. It is also difficult to reproduce the PCMO thin film materials.

In an embodiment of an MOCVD process; a single precursor solution is produced by dissolving the metalorganic precursors in a mixture of organic solvents to produce a single precursor solution. This precursor solution is then used to deposit PCMO thin film materials. The composition of the PCMO thin film materials is further controlled by adjusting process conditions such as vaporizer temperature or substrate temperature. The deposition rates of each element is influenced by these temperatures such that the ratio of the metals with respect to each other can be controlled by adjusting these process parameters, in addition to selecting the ratio of metalorganic precursors. This allows the deposition ratios to be fine tuned.

Experiments can be conducted by one of ordinary skill in the art, based upon the teaching of this description, to determine the affects of changes in vaporizer temperature or substrate temperature on the deposition rates of different precursors. For example, each solid metalorganic precursor Mn(tmhd)₃, Pr(tmhd)₃, and Ca(tmhd)₂ may be separately dissolved in a mixed solvent of butylether and tetraglyme, which are mixed in a volume ratio of 3:1, to produce separate precursor solution with a concentration of between approximately 0.05 and 0.5 M/L for each metal, Pr, Mn, and Ca. These precursor solutions can then be used in an MOCVD chamber to determine the effects of vaporizer temperature and substrate temperature on deposition rates for each precursor solution. For example, the substrate 12.is provided inside the MOCVD chamber 10. The substrate of the current example could be either platinum on a barrier layer, of for example Ti, TiN or TaN, overlying an insulating layer of for example SiO₂ on an underlying silicon substrata, which may be denoted as Pt/(Ti or TiN or TaN)/SiO₂/Si. Another alternative would be to use iridium in place of platinum to provide a substrate structure of Ir/(Ti or TiN or TaN)/SiO₂/Si.

For example, a deposition temperature, which corresponds to the substrate temperature, is set between approximately 400 °C and 500 °C at a pressure of between approximately 1 and 5 torr. Oxygen partial pressure of between approximately 20% and 30% was maintained within the chamber. The vaporizer, along with the delivery lines, was maintained at a temperature of between approximately 240 °C and 280 °C. A precursor solution having 0.1 M/L of the desired metal, Pr, Ca or Mn is delivered into the chamber 10 at a delivery rate of between approximately 0.1 ml/min and 0.5 ml/min. The deposition time was between approximately 20 minutes and 60 minutes depending on film thickness.

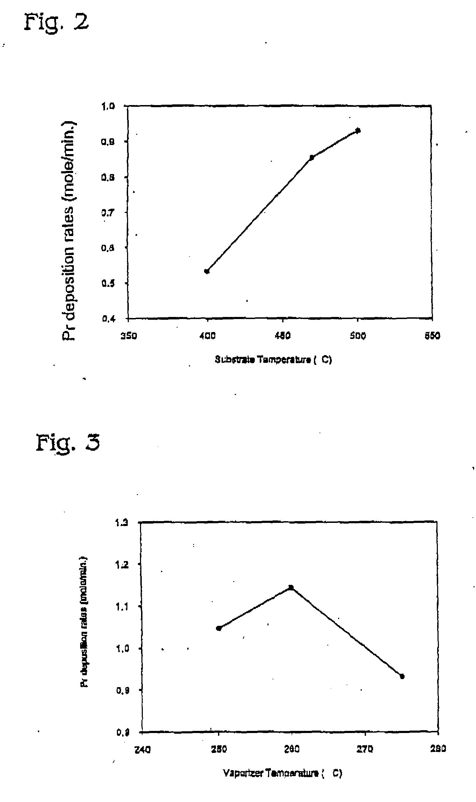

Fig. 2 shows the deposition rate of Pr as a function of substrate temperature for a fixed vaporizer temperature. For the purposes of this measurement the vaporizer temperature was fixed at 275 °C. The deposition rate of Pr increases with increasing substrate temperature, in a nearly linear fashion. The deposition rate of Pr also changes with vaporizer temperature, but not in as linear as the deposition rate of Pr for the increasing substrate temperature, for the temperature ranges considered. Fig. 3 shows the deposition rate of Pr as a function of vaporizer temperature for a fixed substrate temperature. For the measurements shown in Fig. 3, the substrate temperature was fixed at 500 °C.

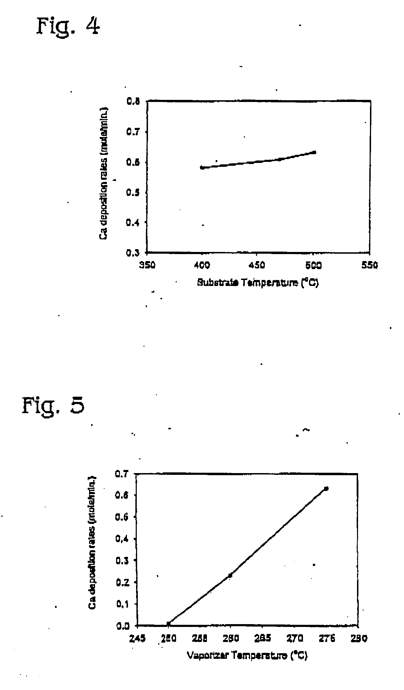

The deposition rate of Ca using Ca(tmhd)₂ was similarly tested as a function of substrate temperature and vaporizer temperature. As shown in Fig. 4, the deposition rate of Ca shows almost no change as a function of temperature within the range tested. However, the deposition rate of Ca does increase with increasing vaporizer temperatures, in a nearly linear fashion, as shown in Fig. 5.

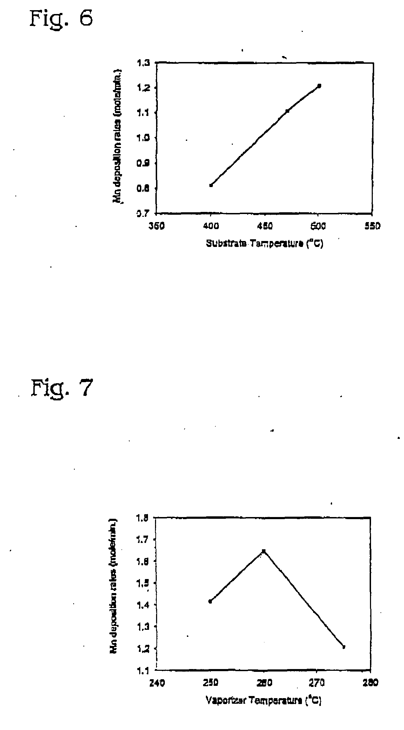

The deposition rates of Mn with substrate and vaporizer temperatures show similar behavior to that shown of Pr. The deposition rate for Mn is fairly linear as a function of substrate temperature as shown in Fig. 6. Fig. 7 show the effect of vaporizer temperature on the deposition rate of Mn. The behavior is very similar to that shown in Fig. 3 for Pr.

In another embodiment of the precursor solution, the solid metalorganic precursors Mn(tmhd)₃, Pr(tmhd)₃, and Ca(tmhd)₂ are dissolved in a mixture of butylether and tetraglyme to produce a single precursor solution with a fixed ratio of Pr:Ca:Mn. Based upon the results of the deposition rates as a function of substrate temperature and vaporizer temperature similar to the measurements shown in Figs. 2-7, a molar ratio of precursor components is established to achieve a PCMO thin film with a composition within a desired range. For example, a preferred ratio was determined to be a molar ratio of between 0.7 : 0.4 : 1.0 and 1.0 : 0.7 : 1.0 for Pr(tmhd)₃, Ca(tmhd)₂, and Mn(tmhd)₃ to produce a PrₓCa₁₋ₓMnO₃ material with x having the desired value of between 0.9 and 0.5. The sold organometallic precursors are then dissolved in a mixed solvent of butylether and tetraglyme, which is mixed in a volume ratio of between 2 :1 and 5 : 1 with a concentration of PCMO metals of between 0.06 M/L and 0.5 M/L.

For purposes of the examples provided here the target value of x is approximately 0.7, which would produce Pr_{0.7}Ca_{0.3}MnO₃. Accordingly, the molar ratio was set to be 0.9 : 0.6 : 1 for Pr(tmhd)₃, Ca(tmhd)₃, and Mn(tmhd)₃. The molar ratio was determined based on the deposition rate of each metal within the range of substrate temperatures and vaporizer temperatures. This may be established using the average deposition rate within the temperature ranges, or by taking the deposition rate at the middle of the temperature ranges. The final composition can later be fine tuned by further adjusting the substrate temperature and the vaporizer temperature. The solid metalorganic precursors were dissolved in a mixed solvent of butyl ether and tetraglyme, which is mixed in a volume ratio of 3:1. The resulting precursor solution has a concentration of 0. 1 M/L of metals for PCMO deposition. This single solution precursor is injected into the vaporizer 42 at temperatures in the range of between approximately 240 °C and 280 °C by a micro-pump 44 at a rate of between. approximately 0.2 ml/mm and 0.4 ml/min to form precursor vapors. The feed line was kept at a temperature of between approximately 240 °C and 280 °C. The substrate temperature is fixed at a temperature in the range of between approximately 400°C and 500 °C. By fixing the substrate temperature and selecting a vaporizer temperature it would be possible to fine tune the ratio of Ca : (Pr + Mn). The composition of the resulting PCMO thin films may be measured using energy dispersive x-ray (EDX).

### Example 1

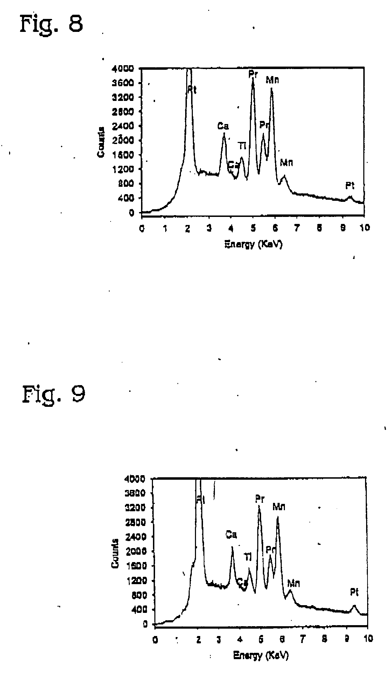

The substrate is fixed at 500 °C and the vaporizer temperature is selected to be 270 °C. This will produce a PCMO thin film. with a composition indicated by the EDX shown in Fig. 8

### Example 2

The substrate is fixed at 600 °C and the vaporizer temperature is selected to be 275 °C. This will produce a PCMO thin film with a composition indicated by the EDX shown in Fig. 9

Comparing the results in Fig. 8 to those in Fig. 9, it is clear that the ratio of Ca to Pr and Mn has changed. Thus it would be possible to fix the substrate temperature and adjust the vaporizer temperature until a preferred, or desired, composition is achieved. This composition should then be repeatable by controlling the ratio of metalorganic precursors as well as the substrate temperature and vaporizer temperature. It may also be possible to make fine adjustments to the composition without the need to change the precursor solution itself.

It is also possible to use the single solution, to fix the vaporizer temperature and to adjust the composition by selecting the substrate temperature.

### Example 3

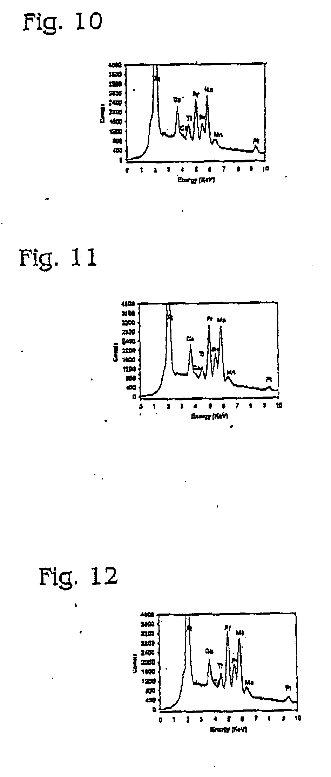

The vaporizer temperature is fixed at 275 °C, and the substrate temperature is selected at 400 °C. This will produce a PCMO thin film with a composition indicated by the EDX shown in Fig. 10

### Example 4

The vaporizer temperature is fixed at 275°C, and the substrate temperature is selected at 450 °C. This will produce a PCMO thin film With a composition indicated by the EDX shown in Fig. 11

### Example 5

The vaporizer temperature is fixed at 275 °C, and the substrata temperature is selected at 500 °C. This will produce a PCMO thin film with a composition indicated by the EDX shown in Fig. 12

By comparing Figs 10 -12, it is apparent that the composition of the resulting PCMO thin film can be adjusted using the substrate temperature, with a fixed vaporizer temperature. This will provide an additional means to control the ratio of Pr : Ca : Mn in the resulting film using the same single solution precursor.

While the present invention has been particularly shown and described with respect to exemplary and preferred embodiments, it will be understood that the changes in form and detail may be made without departing from the scope of the present invention. The present invention should not be limited to any exemplary or preferred embodiment, but rather should be limited only by the claims.

## Claims

1. A single section MOCVD precursor for depositing PCMO comprising a Pr(tmhd)₃ precursor, a Mn(tmhd)₃ precursor and a calcium precursor dissolved in an organic solvent.

2. The precursor of claim 1, wherein the calcium precursor is Ca(tmhd)₂.

3. The precursor of claim 1, wherein the calcium precursor is Ca(hfac)₂.

4. The precursor of claim 1, wherein the organic solvent comprises butylether.

5. The precursor of claim 1, wherein the organic solvent comprises tetraglyme.

6. The precursor of claim 1, wherein the organic solvent comprises butylether and tetraglyme in a volumetric ratio of between 2:1 and 5:1.

7. The precursor of claim 1, wherein the organic solvent comprises butylether and tetraglyme in a volumetric ratio of 3:1.

8. The precursor of claim 1, wherein the organic solvent comprises a solvent selected from the group consisting of octane, THF, butyl acetate, and iso-propanol.

9. The precursor of claim 1, wherein the Pr(tmhd)₃ precursor, the Mn(tmhd)₃ precursor and the calcium precursor provide between 0.05 and 0.5 M/L of metals to be deposited.

10. The precursor of claim 1, wherein the Pr(tmhd)₃ precursor, the Mn(tmhd)₃ precursor and the calcium precursor provide approximately 0.1 M/L of metals to be deposited.

11. An MOCVD process for depositing PCMO comprising:
a) providing a substrate within an MOCVD chamber;
b) introducing oxygen into the MOCVD chamber;
c) heating the substrate to a predetermined substrate temperature;
d) heating a vaporizer attached to the MOCVD chamber to a predetermined vaporizer temperature;
e) introducing a single solution precursor comprising a Pr precursor, a Ca precursor and an Mn precursor dissolved in an organic solvent at a predetermined molar ratio into the vaporizer, whereby the precursor is vaporized to form a precursor vapor; and
f) delivering the precursor vapor into the chamber using a carrier gas, whereby the precursor vapor deposits a thin film of PCMO on the substrate.

12. The MO CVD process of claim 11, wherein the substrate comprises platinum, or iridium, overlying silicon.

13. The MOCVD process of claim 11, wherein the MOCVD chamber is at a pressure of between approximately 1 and 5 torr.

14. The MOCVD process of claim 11, wherein the MOCVD chamber has an oxygen partial pressure of between approximately 20% and 30%.

15. The MOCVD process of claim 11, wherein the predetermined substrate temperature is between approximately 400 °C and 500 °C.

16. The MOCVD process of claim 11, wherein the predetermined vaporizer temperature is between approximately 240°C and 280°C.

17. The MOCVD process of claim 11, wherein the single solution precursor comprises Pr(tmhd)₃, Ca(tmhd)₂ and Mn(tmhd)₃ dissolved in an organic solvent.

18. The MOCVD process of claim 11, wherein the single solution precursor comprises Pr(tmhd)₃, Ca(tmhd)₂ and Mn(tmhd)₃ with a molar ratio in the range of (0.7-1.0) : (0.4-0.7) : 1 dissolved in a mixed organic solvent of butylether and tetraglyme in a volumetric ratio of between 2 : 1 and 5 : 1.

19. The MOCVD process of claim 11, wherein the single solution precursor comprises Pr(tmhd)₃, Ca(tmhd)₂ and Mn(tmhd)₃ with a molar ratio of 0.9 : 0.6 :1 dissolved in a mixed organic solvent of butyl ether and tetraglyme in a volumetric ratio of 3:1.

20. The MOCVD process of claim 19, wherein the single solution precursor has a total concentration of between approximately 0.06 M/L and 0.5 M/L of the metals Pr, Ca, Mn combined.

21. The MOCVD process of claim 20 wherein the single solution precursor has a total concentration of approximately 0.1 M/L of the metals Pr, Ca, Mn combined.

22. The MOCVD process of claim 11, wherein the single solution precursor comprises Pr(tmhd)₃, Ca(hfac)₂ and Mn(tmhd)₃ dissolved in an organic solvent.

23. The MOCVD process of claim 11 further comprising determining the molar ratio of the Pr precursor, the Ca precursor and the Mn precursor by preparing separate precursor solutions for each solid metalorganic precursor and determining the deposition rats for each precursor over a range of substrate temperatures and vaporizer temperatures and establishing the amount of each precursor needed to produce a final material with the desire concentrations of each metal component.

24. The MOCVD process of claim 11 further comprising determining the predetermined substrate temperature by testing the composition of PCMO materials using a fixed vaporizer temperature at different substrate temperatures.

25. The MOCVD process of claim 11 further comprising determining the predetermined vaporizer temperature by testing the composition of PCMO materials using a fixed substrate temperature at different vaporizer temperatures.
